Europäisches Patentamt

European Patent Office

Office européen des brevets

(19)

(11) Numéro de publication: **0 077 248**
**B1**

(12) **FASCICULE DE BREVET EUROPEEN**

(45) Date de publication du fascicule du brevet:
10.12.86

(51) Int. Cl.⁴: **H 03 J 7/32**

(21) Numéro de dépôt: **82401797.4**

(22) Date de dépôt: **01.10.82**

(54) Dispositif de réduction du taux de fausses alarmes, et récepteur de surveillance comportant un tel dispositif.

(30) Priorité: **09.10.81 FR 8119073**

(43) Date de publication de la demande:
**20.04.83 Bulletin 83/16**

(45) Mention de la délivrance du brevet:
**10.12.86 Bulletin 86/50**

(84) Etats contractants désignés:
**DE GB**

(56) Documents cités:
**DE - A - 2 812 954**
**FR - A - 2 290 797**
**US - A - 4 114 105**

**ELECTRONIC DESIGN, vol. 26, no. 18, 1 septembre 1978, pages 130-132, Rochelle Park, USA R.T. HART: "Blank noise effectively with F.M.**

(73) Titulaire: **THOMSON-CSF, 173, Boulevard Haussmann, F-75379 Paris Cedex 08 (FR)**

(72) Inventeur: **Souchay, Philippe, THOMSON-CSF SCPI 173, bld Haussmann, F-75379 Paris Cedex 08 (FR)**
Inventeur: **Glorie, Maurice, THOMSON-CSF SCPI 173, bld Haussmann, F-75379 Paris Cedex 08 (FR)**

(74) Mandataire: **Turlèque, Clotilde et al, THOMSON-CSF SCPI 19, avenue de Messine, F-75008 Paris (FR)**

## Description

La présente invention concerne les dispositifs permettant de réduire le taux des fausses alarmes déclenchées par un récepteur de surveillance d'une bande de fréquences radioélectriques.

Un récepteur de surveillance a pour fonction de détecter toute émission radioélectrique présente dans une certaine bande de fréquences, appelée sous-gamme, constituée d'une partie de la gamme VHF par exemple, et de déclencher une alarme lorsqu'une émission est détectée. La détection d'émissions parasites, notamment de bruits naturels, est la cause du déclenchement de fausses alarmes indésirables.

Le bruit recueilli par l'antenne du récepteur est composé de trois types de bruit:
– du bruit non stationnaire, de nature impulsionnelle,
– du bruit stationnaire à moyen terme, dont les caractéristiques sont susceptibles d'évoluer dans le temps et en fonction de la bande de fréquences surveillée,
– du bruit stationnaire à long terme, d'origine thermique par exemple.

Un récepteur de surveillance comporte principalement un détecteur d'énergie précédé d'un filtre à fréquence fixe et d'un changeur de fréquence permettant de recevoir sur une fréquence variable, ou précédé d'un banc de filtres. Il est classique de coupler le détecteur d'énergie à un comparateur muni d'un seuil fixe pour déclencher une alarme lorsqu'un signal reçu a une énergie supérieure à la valeur du seuil. Cette valeur peut être réglée pour être supérieure à la valeur moyenne du bruit stationnaire à long terme.

Il est connu d'intercaler sur la sortie du comparateur une porte logique qui est inhibée par des moyens de détection des signaux de bruit impulsionnel. Un tel dispositif est décrit dans le brevet allemand DE-A-2 812 954.

L'inconvénient d'un tel dispositif est de ne pas tenir compte des variations du bruit stationnaire à moyen terme, d'une part pour détecter les signaux utiles et d'autre part pour détecter les signaux de bruit impulsionnel. Le taux de fausse alarme varie donc avec le niveau du bruit stationnaire à moyen terme, qui dépend notamment de la fréquence surveillée.

La présente invention a pour but d'éviter cet inconvénient.

Selon l'invention, un dispositif de réduction du taux de fausses alarmes pour un récepteur de surveillance d'une bande de fréquences radioélectriques, comportant une porte recevant un signal logique d'alarme lorsqu'une émission est reçue sur une fréquence surveillée, et le transmettant si d'une part, elle est validée par des moyens de détection des signaux dont l'énergie est supérieure à un seuil de valeur $S''$, et si, d'autre part, elle n'est pas inhibée par des moyens de détection des bruits impulsionnels, est caractérisé en ce que la valeur $S''$ est fonction d'une valeur B obtenue à partir du calcul d'une moyenne à moyen terme des énergies de bruit reçues sur plusieurs fréquences voisines de la fréquence surveillée.

L'invention a également pour objet un récepteur de surveillance comportant un tel dispositif.

L'invention sera mieux comprise et d'autres caractéristiques apparaîtront à l'aide des figures et de la description correspondante.

– La figure 1 représente le schéma synoptique d'un exemple de réalisation d'un récepteur de surveillance comportant un dispositif selon l'invention.

– La figure 2 représente un schéma synoptique plus détaillé d'une partie de ce récepteur.

– La figure 3 représente un exemple d'organigramme de fonctionnement d'une partie de ce récepteur.

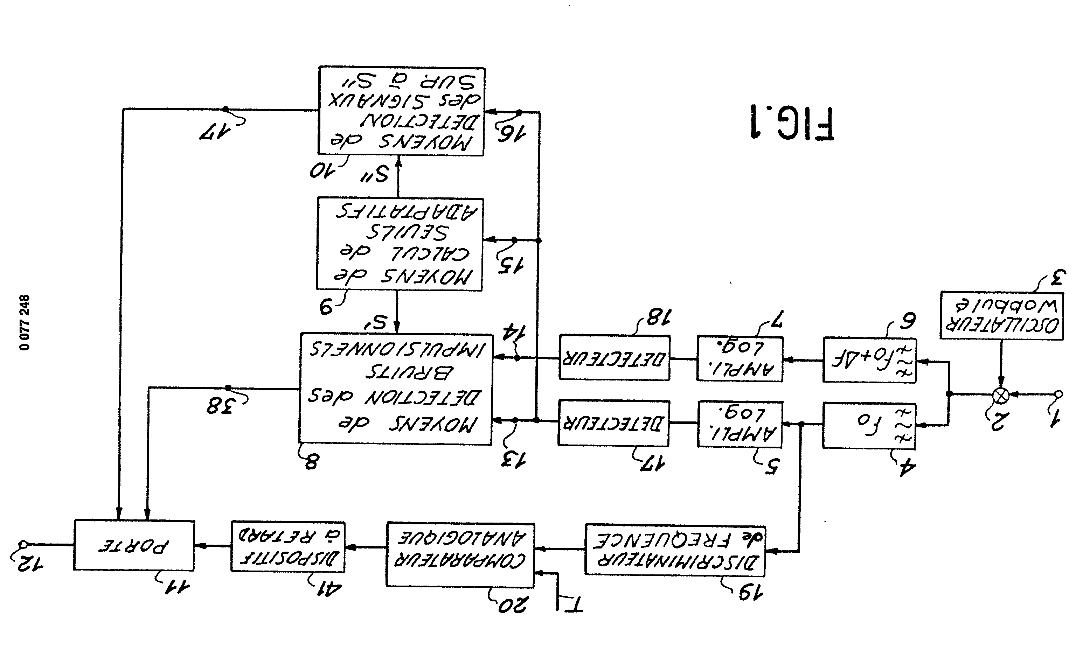

La figure 1 représente le schéma synoptique d'un exemple de réalisation d'un récepteur de surveillance muni d'un dispositif selon l'invention. Le signal reçu par une antenne est appliqué par une borne d'entrée 1 à un chargeur de fréquence 2. Celui-ci reçoit aussi, d'un oscillateur local 3, un signal dont la fréquence est wobbulée. La sortie du changeur de fréquence 2 alimente un premier filtre passe-bande 4 de fréquence centrale $f_0$, qui est couplé à un discriminateur de fréquence 19, non saturé. Ce discriminateur est très sélectif, c'est-à-dire qu'il fournit une impulsion de durée très courte lorsque la fréquence d'accord passe sur une fréquence où est effectuée une émission. L'amplitude de cette impulsion permet de connaître l'énergie de l'émission détectée. Elle est comparée à un seuil fixe T, par un comparateur analogique 20. La sortie de ce comparateur fournit un signal logique d'alarme lorsque le signal reçu a une amplitude supérieure au seuil T, qui correspond à l'énergie des plus faibles émissions à détecter. Le changeur de fréquence 2, l'oscillateur wobbulé 3, le filtre 4, le discriminateur 19 et le comparateur 20 constituent un récepteur de surveillance classique. Le signal fourni par le comparateur 20 permet de donner l'alarme quand une émission est détectée mais, malheureusement, le taux de fausses alarmes est élevé.

Le récepteur selon l'invention comporte en outre une porte logique 11, à laquelle est appliqué le signal fourni par le comparateur 20. Cette porte ne laisse passer ce signal que dans le cas où elle est validée simultanément par un signal logique fourni par des moyens 8 de détection des bruits impulsionnels et par un signal logique fourni par des moyens 10 de détection des signaux d'énergie supérieure à un seuil $S''$.

La sortie du changeur de fréquence 2 alimente un deuxième filtre passe-bande de fréquence centrale $f_0 + \Delta f$, et de bande passante b, égale à celle du premier filtre. Pour chaque valeur de la fréquence de l'oscillateur local le récepteur peut donc recevoir sur un premier et un deuxième canal dont les fréquences centrales diffèrent de $\Delta f$.

Les deux filtres passe-bande, 4 et 6, sont couplés respectivement à deux amplificateurs logarithmiques 5 et 7, qui permettent d'amplifier les signaux reçus avec une très grande dynamique.

Chacun de ces amplificateurs alimente un détecteur d'énergie, respectivement 17 et 18, qui fournit une valeur analogique de l'énergie reçue dans le canal surveillé. La valeur fournie par le détecteur 17 est transmise à des moyens 9 de calcul de deux seuils adaptatifs par une borne d'entrée 15, aux moyens 8 de détection des bruits impulsionnels par une borne d'entrée 13 et aux moyens 10 de détection des signaux d'énergie supérieure à un seuil de valeur S″ par une borne d'entrée 16. La valeur fournie par le détecteur 18 est transmise aux moyens 8 de détection des bruits impulsionnels par une borne d'entrée 14. Les moyens 9 de calcul de seuils adaptatifs déterminent deux valeurs de seuil S′ et S″ en fonction de l'énergie moyenne du bruit stationnaire à long et moyen termes dans une bande de fréquence encadrant la fréquence surveillée. Ces valeurs de seuil sont fournies respectivement aux moyens de détection 8 et 10. Quand une émission non parasite est reçue, les moyens de détection 10 détectent un signal dont l'énergie est supérieure au seuil S″, ils fournissent alors à la porte 11 par leur sortie 17 un signal logique de validation.

Les moyens de détection 8 fournissent par leur sortie 38 un signal de validation à la porte 11, sauf quand le récepteur reçoit un bruit impulsionnel. Dans ce dernier cas, deux signaux d'énergie supérieure au seuil S′ sont détectés simultanément sur les sorties des deux filtres 4 et 6 car un bruit impulsionnel a un spectre très étendu. Les moyens de détection 8 suppriment alors momentanément la validation de la porte.

La porte 11 ne transmet donc le signal logique d'alarme que dans les cas où le signal reçu n'est pa dû à un bruit impulsionnel et si son énergie est supérieure au seuil S″, qui est choisi supérieur à l'amplitude moyenne du bruit stationnaire à long et moyen termes.

Le signal logique d'alarme fourni par le comparateur 20 est transmis à la porte 11 par l'intermédiaire d'un dispositif à retard 41, qui fournit un délai correspondant au délai de réaction des moyens de détection 8 et 10.

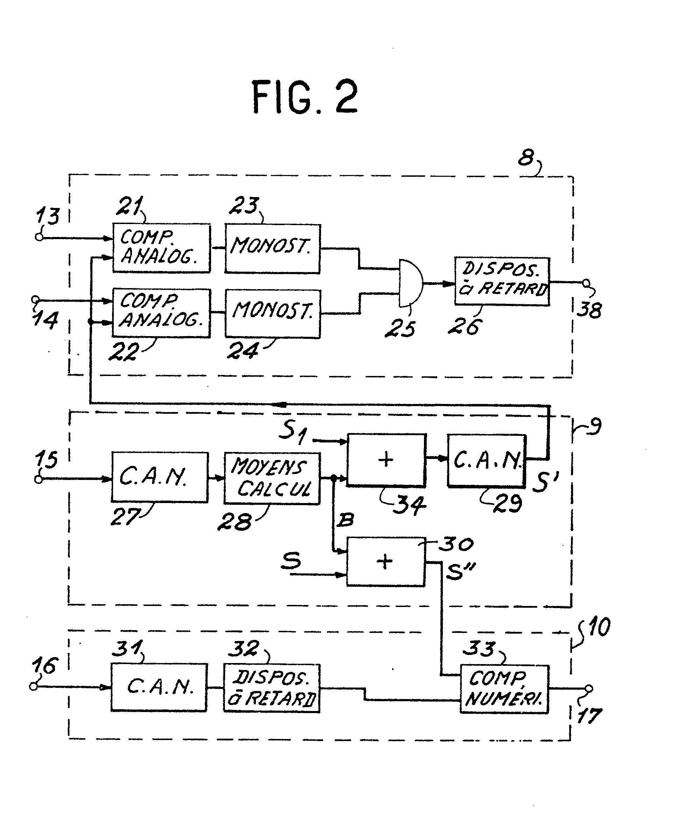

La figure 2 représente un schéma synoptique partiel plus détaillé de l'exemple de réalisation décrit ci-dessus. La borne d'entrée 15 des moyens 9 de calcul de seuils adaptatifs transmet une valeur analogique de l'énergie du signal reçu, à l'entrée d'un convertisseur analogique-numérique 27. La valeur numérique qu'il génère est fournie à une entrée de moyens de calcul 28 qui déterminent une valeur moyenne B de l'énergie du bruit stationnaire à long et moyen termes dans une bande centrée sur la fréquence d'accord du premier canal du récepteur. La valeur B est fournie à une première entrée d'un additionneur numérique 34, recevant sur une deuxième entrée une valeur fixe $S_1$. La valeur numérique $B + S_1$ fournie par l'additionneur 34 est convertie en une valeur analogique, qui constitue la valeur de seuil S′, par un convertisseur numérique-analogique 29. D'autre part la valeur numérique B est appliquée à une première entrée d'un additionneur 30, qui reçoit sur une deuxième entrée une valeur numérique S fixe. La valeur fournie par la sortie de l'additionneur 30 constitue la valeur de seuil S″. Cette valeur peut être réglée en fonction du taux de fausses alarmes admissible et de la sensibilité désirée. Si la valeur du seuil S″ est augmentée le taux de fausses alarmes est diminué, mais la sensibilité du récepteur est affaiblie.

Le bruit impulsionnel se traduit par l'occupation d'un spectre instantané très large, contrairement aux autres bruits dont le spectre instantané est très réduit, et contrairement aux émissions non parasites. Cette caractéristique permet de discriminer les bruits impulsionnels. Les moyens 8 de détection des bruits impulsionnels reçoivent par les bornes d'entrée 13 et 14 les valeurs analogiques des énergies des signaux reçus à un même instant dans les deux canaux surveillés. Ces valeurs sont appliquées respectivement à une première entrée d'un comparateur analogique 21 et à une première entrée d'un comparateur analogique 22. La valeur de seuil S′ est appliquée à une deuxième entrée de chacun de ces comparateurs 21 et 22. Chacun de ces comparateurs possède une sortie déclenchant chacune un monostable, respectivement 23 et 24, couplé respectivement à une première et à une deuxième entrée d'une porte logique ET 25. Une sortie de cette porte logique 25 fournit un signal logique si, et seulement si, chacun des canaux surveillés reçoit simultanément un signal dont l'amplitude est supérieure au seuil S′. Ce signal logique est retardé par un dispositif à retard 26, puis est fourni, à travers la borne de sortie 38, à une première entrée de la porte 11, pour l'inhiber.

Les moyens 10 de détection des signaux d'énergie supérieure à un seuil S″, reçoivent par la borne d'entrée 16 une valeur analogique de l'énergie du signal reçu sur le premier canal. Cette valeur est mise sous forme numérique par un convertisseur analogique-numérique 31, qui peut être confondu avec le convertisseur analogique-numérique 27 des moyens de calcul 9. La valeur numérique fournie par le convertisseur 31 est retardée par un dispositif à retard 32 puis est fournie à une première entrée d'un comparateur numérique 33. Une deuxième entrée de ce comparateur 33 reçoit la valeur de seuil S″, et une sortie fournit un signal logique quand la valeur de l'énergie reçue est supérieure à la valeur de seuil S″. Ce signal logique est appliqué, par l'intermédiaire de la borne de sortie 17, à une deuxième entrée de la porte 11 pour la valider.

La valeur fixe S est choisie supérieure à la valeur $S_1$.

$$\left. \begin{array}{l} S'' = S + B \\ S > S_1 \\ S' = B + S_1 \end{array} \right\} \Rightarrow S'' > S'$$

La valeur de seuil S′ est inférieure à la valeur de seuil S″ afin de mieux assurer la détection des bruits impulsionnels; en effet la probabilité de détection simultanée, sur les deux canaux, d'un signal parasite est plus faible que sa probabilité de détection sur le premier canal seulement.

Le dispositif à retard 32 laisse un délai aux moyens 9 de calcul de seuil pour effectuer le calcul de la valeur moyenne de l'énergie du bruit.

Le signal logique fourni par les moyens de détection 10 a un certain retard par rapport à l'instant de réception d'une émission. Pour que le signal logique fourni par les moyens de détection 10 coïncide avec le signal logique fourni par les moyens de détection 8, ceux-ci comprennent le dispositif à retard 26, mentionné précédemment.

La valeur de l'écart de fréquence $\Delta f$ est choisie suffisamment grande pour qu'une émission non parasite ayant une forte excursion de fréquence ne soit pas prise pour un bruit impulsionnel.

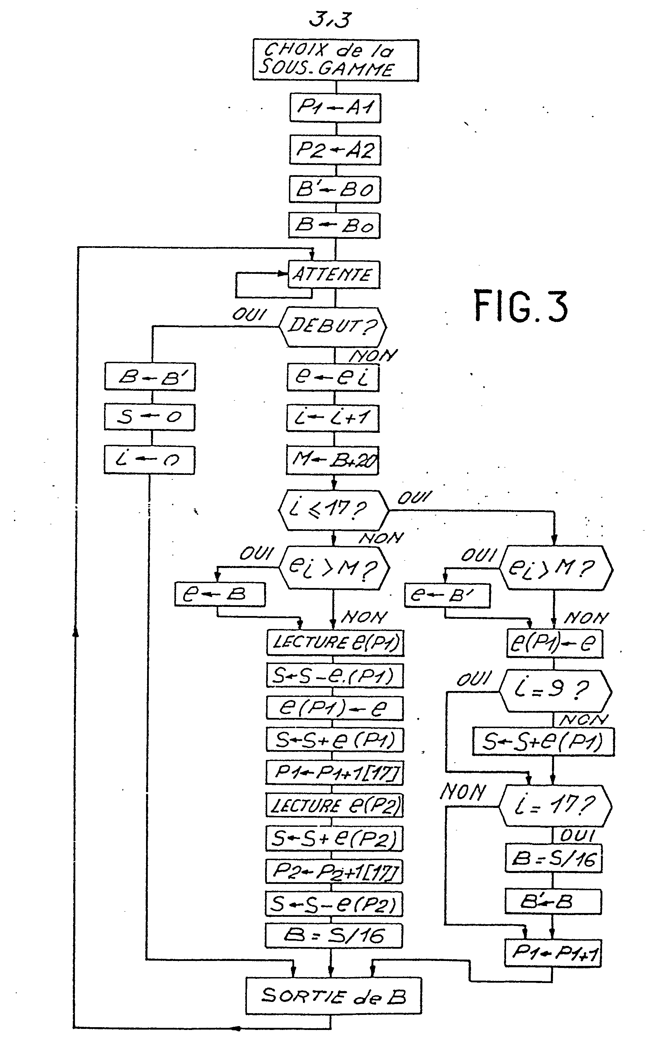

La figure 3 représente un exemple d'organigramme des opérations effectuées par les moyens de calcul 28 pour fournir une valeur moyenne B de l'énergie du bruit stationnaire à long et moyen termes présent dans un canal de largeur b.

La valeur B est très variable en fonction de la portion du spectre de fréquence qui est considérée, c'est pourquoi B est calculée sur une bande de fréquence de faible largeur, centrée sur la fréquence du canal surveillé et se déplaçant avec elle. A chaque instant d'échantillonnage le convertisseur analogique-numérique 27 fournit une valeur de l'énergie reçue dans un canal de largeur b. Dans cet exemple la valeur B est la valeur moyenne des énergies reçues successivement dans seize canaux voisins situés, dans le spectre, de part et d'autre du canal surveillé. Le nombre de canaux est choisi suffisamment élevé pour que les fluctuations de la valeur moyenne B, à chaque changement de canal, reste négligeable. Plus le nombre de canaux est grand plus l'effet de lissage est important, mais ce nombre est limité d'une part par la complexité de la réalisation et d'autre part par la nécessité de ne prendre en compte que des fréquences proches de la fréquence surveillée.

Lors du balayage du début de la sous-gamme à surveiller, pendant dix-sept périodes d'échantillonnage, cette valeur B n'est pas calculable, puisque les seize valeurs d'énergie ne sont pas encore disponibles. Pendant ce laps de temps la valeur moyenne de l'énergie de bruit utilisée pour calculer S' et S'' est la valeur B' calculée lors du précédent balayage de ce début de sous-gamme. Lorsqu'une sous-gamme est balayée pour la première fois, cette valeur B' est remplacée par une valeur $B_0$ fixée une fois pour toutes.

La valeur de l'énergie reçue dans le $i^{ème}$ canal est notée $e_i$, où i est un nombre entier positif. Cette valeur n'est pas prise en compte si elle est supérieure à une valeur borne M pour éviter de fausser la moyenne quand une émission non parasite est reçue dans un des seize canaux. D'autre part, la valeur de l'énergie reçue dans le canal médian, sous surveillance, n'est pas prise en compte. Les valeurs d'énergie supérieures à M sont remplacées par une valeur égale à la valeur moyenne B. La valeur M est égale, par exemple, à la valeur B+20dB et varie en fonction de B.

Les moyens de calcul 28 sont constitués, dans cet exemple, par un microprocesseur et des mémoires RAM et ROM. Les valeurs de l'énergie reçue sont stockées dans une table permettant de contenir dix-sept valeurs, deux registres pointeurs permettent de connaître l'adresse de la valeur la plus ancienne et l'adresse de la valeur de l'énergie reçue dans le canal surveillé.

La séquence des opérations commence à l'instant où est choisie la sous-gamme à balayer.

Un premier registre pointeur $P_1$, désignant l'adresse la plus ancienne des dix-sept valeurs stockées, est initialisé à une valeur $A_1$, valeur d'adresse la moins élevée parmi les adresses des cases mémoires réservées pour constituer la table des valeurs d'énergie.

Soit $e(P_1)$ le contenu de la case mémoire pointée par le premier registre pointeur.

Un deuxième registre pointeur $P_2$, désignant l'adresse de la valeur d'énergie reçue dans le canal surveillé, est initialisé à une valeur $A_2$, valeur d'adresse médiane dans la table.

Soit $e(P_2)$ le contenu de la case mémoire pointée par le deuxième pointeur.

Un registre appelé B' est destiné à contenir la valeur moyenne B' de l'énergie du bruit reçu dans les dix-sept premiers canaux de la sous-gamme lorsqu'elle a déjà été balayée au moins une fois. Ce n'est pas le cas considéré ici, il est donc initialisé avec la valeur $B_0$ fixe.

$$B' \leftarrow B_0$$

Un registre, appelé B, est destiné à contenir la valeur moyenne B de l'énergie du bruit reçu dans les seize canaux. Il est initialisé avec la même valeur $B_0$.

$$B \leftarrow B_0.$$

Puis le microprocesseur décrit une boucle d'attente jusqu'à ce qu'il reçoive un signal d'interruption. Il peut y avoir deux types d'interruption: un premier type d'interruption annonce le début d'un balayage de la sous-gamme. Un deuxième type annonce qu'une valeur d'énergie $e_i$ est prête à être traitée.

Dans le premier type, la valeur B' est transférée à la place de la valeur B.

$$B \leftarrow B'$$

Si la sous-gamme est balayée pour la première fois $B = B' = B_0$, sinon $B = B'$, valeur moyenne de l'énergie du bruit dans les dix-sept premiers canaux de la sous-gamme, calculée lors du précédent balayage. Un registre, appelé S, destiné à mémoriser une valeur S de la somme de seize valeurs d'énergie, est initialisé à zéro. Un registre, appelé i, destiné à compter le rang i de la valeur d'énergie reçue $e_i$, est initialisé à 0:

$$S \leftarrow 0 \quad i \leftarrow 0$$

Puis la valeur $B = B' = B_0$ est fournie à la sortie du microprocesseur et celui-ci repasse en attente.

La valeur $B = B_0$ ainsi disponible avant même le traitement de la valeur d'énergie reçue dans le premier canal, permet de fixer le seuil $S'$ et $S''$ pour la surveillance des dix-sept premiers canaux de la sous-gamme lors de son premier balayage.

Le deuxième type d'interruption annonce qu'une valeur d'énergie est prête à être traitée. Cette valeur, $e_i$, est lue par le microprocesseur et est stockée dans un registre appelé e:

$$e \leftarrow e_i.$$

Le registre i est incrémenté d'une unité:

$$i \leftarrow i + 1$$

Un registre, appelé M, est destiné à stocker la valeur borne M. Il est chargé avec la valeur $B + 20\text{dB}$:

$$M \leftarrow B + 20\text{dB}$$

Le contenu du registre i est testé, s'il est inférieur ou égal à 17, le traitement n'en est qu'à une phase de démarrage où il n'est pas encore possible de calculer une valeur moyenne B sur 17 valeurs. La séquence d'opérations comporte donc une branche particulière qui réalise les opérations suivantes:

La valeur d'énergie reçue $e_i$, contenue dans le registre e, est comparée à la borne M et elle est remplacée par la valeur $B' = B_0$ si elle dépasse cette borne, sinon elle est inchangée.

$$e > M \Rightarrow e \leftarrow B'$$

Puis la valeur $e_i$, ou la valeur qui la remplace, est inscrite dans la table à l'adresse pointée par le premier pointeur $P_1$.

$$e(P_1) \leftarrow e$$

La première valeur, $e_1$, est donc inscrite dans la première adresse de la table, la deuxième valeur, $e_2$, à la deuxième adresse, etc...

Le registre i est testé; si son contenu est différent de 9, ($i < 9$ ou $i > 9$) la dernière valeur reçue, ou la valeur $B'$ la remplaçant, est additionnée au contenu du registre S,

$$S \leftarrow S + e(P_1)$$

Sinon S est inchangée. La neuvième valeur, $e_9$, correspondant au canal surveillé, n'est pas prise en compte.

Le contenu du registre i est testé une dernière fois, si sa valeur atteint 17 la première valeur moyenne B peut être calculée

$$B = \frac{S}{16}$$

Cette valeur B servira lors de la phase de démarrage du balayage suivant, à la place de la valeur arbitraire $B_0$. Pour la conserver elle est stockée dans le registre $B'$:

$$B' \leftarrow B.$$

Le premier registre pointeur est incrémenté d'une unité.

$$P_1 \leftarrow P_1 + 1$$

La valeur B est transmise sur la sortie du microprocesseur, puis celui-ci repasse en attente d'une interruption.

Si, après l'entrée d'une valeur $e_i$, le test du contenu du registre i indique que le rang i est supérieur à 17, la valeur $e_i$ est traitée selon une troisième branche.

Dans cette troisième branche une moyenne glissante est effectuée. La table est réactualisée, comme si les valeurs étaient dans un registre à décalage. La valeur $e_i$, contenue dans le registre e, est comparée à la borne M et est remplacée par la valeur B précédemment déterminée si $e_i$ est supérieure à M. Sinon $e_i$ est inchangée.

La valeur $e_i$, ou B, est écrite dans la table à la place de la valeur la plus ancienne, $e(P_1)$, pointée par le registre $P_1$. Mais juste avant d'être remplacée par $e_i$, la valeur la plus ancienne a été lue et soustraite au contenu du registre S:

$$S \leftarrow S - e(P_1) \text{ puis } e(P_1) \leftarrow e$$

Puis le premier pointeur, $P_1$, est incrémenté d'une unité, modulo 17, pour pointer la case mémoire suivante qui contient désormais la valeur plus ancienne parmi les valeurs restantes:

$$P_1 \leftarrow P_1 + 1 \ (17)$$

Le calcul de la valeur moyenne ne devant pas tenir compte de la valeur d'énergie reçue dans le canal surveillé, celle-ci doit être soustraite de la somme S; par contre, la valeur d'énergie reçue dans le canal surveillé immédiatement précédemment, doit être réintégrée dans cette somme S. Cette valeur, $e(P_2)$, est lue dans la case mémoire pointée par le pointeur $P_2$ puis est soustraite au contenu du registre S:

$$S \leftarrow S + e(P_2)$$

Le pointeur $P_2$ est incrémenté d'une unité, modulo 17, pour pointer la valeur correspondant au canal surveillé à l'instant considéré. Ensuite cette valeur $e(P_2)$ est lue puis soustraite au contenu du registre S:

$$P_2 \leftarrow P_2 + 1 \ (17)$$
$$S \leftarrow S - e(P_2)$$

La somme des énergies reçues dans les seize canaux de part et d'autre du canal surveillé étant déterminée, il suffit de la diviser par 16 pour obtenir la valeur moyenne B de ces énergies.

$$B = \frac{S}{16}$$

La valeur moyenne B est fournie sur la sortie du microprocesseur, puis celui-ci passe en attente d'une interruption.

La valeur B utilisée pour fixer les seuils de détection dans un $j^{ième}$ canal est calculée après avoir balayé les fréquences du $j-8^{ième}$ canal au $j+8^{ième}$ canal. Le signal logique d'alarme correspondant au $j^{ième}$ canal est retardé par le dispositif à retard 41 afin de compenser le délai de calcul de la valeur B, et des signaux de validation de la porte 11.

La réalisation des moyens de calcul 28 est à la portée de l'homme de l'art. De nombreuses variantes sont possibles en ce qui concerne le matériel et l'algorithme utilisés. Il est possible, notamment, d'utiliser un nombre de valeurs différent de 16 pour effectuer le calcul d'une valeur moyenne de l'énergie du bruit dans un canal.

D'autre part, il est possible de remplacer l'acquisition en série des 16 valeurs par une acquisition en parallèle, en particulier si le dispositif réalisé est destiné à équiper un récepteur utilisant à la place de l'oscillateur wobbulé, un oscillateur à fréquence fixe, et à la place d'un filtre unique pour les étages à fréquence intermédiaire, un banc de filtres. L'acquisition en parallèle des 16 valeurs présente l'avantage d'une plus grand rapidité de balayage, par rapport à l'acquisition en série, pour une même sous-gamme.

Il est aisé de réaliser les moyens de détection 10 de telle façon qu'ils traitent des signaux analogiques et non pas numériques: le convertisseur analogique numérique 31 disparaît; le dispositif à retard 32 et le comparateur 33 sont analogiques; un convertisseur numérique-analogique est rajouté pour fournir une valeur analogique du seuil S'' au comparateur 33.

Il est à la portée de l'homme de l'art de réaliser des moyens 8 de détection des bruits impulsionnels, où ceux-ci ne sont pas détectés par la coïncidence temporelle des signaux reçus sur deux fréquences différentes, mais par leur faible durée. Les deux canaux de réception balayent une même fréquence à deux instants séparés d'un temps $\Delta T$. Une émission parasite impulsionnelle, ayant une durée extrêmement courte, n'est pas détectée deux fois sur cette même fréquence avec un intervalle de temps de durée $\Delta T$. Par contre, une émission non parasite est reçue sur les deux canaux avec un écart de temps $\Delta T$. Si $\Delta T$ est constant, il est aisé par un dispositif à retard de remettre en synchronisme les signaux non parasites, et de les détecter par coïncidence. La valeur de $\Delta T$ est choisie de façon à être supérieure à la durée de la plupart des parasites impulsionnels.

Une variante de réalisation du récepteur consiste à utiliser un filtre à fréquence intermédiaire indépendant des filtres utilisés pour le dispositif de réduction du taux de fausses alarmes, car il n'est pas nécessaire d'avoir la même bande passante pour la surveillance, d'une part, et la mesure du bruit, d'autre part.

**Revendications**

1. Dispositif de réduction du taux de fausses alarmes pour un récepteur de surveillance d'une bande de fréquences radioélectriques, comportant une porte (11) recevant un signal logique d'alarme lorsqu'une émission est reçue sur une fréquence surveillée, et le transmettant si d'une part elle est validée par des moyens (10) de détection des signaux dont l'énergie est supérieure à un seuil de valeur S'', et si, d'autre part, elle n'est pas inhibée par des moyens (8) de détection des bruits impulsionnels, caractérisé en ce que la valeur S'' est fonction d'une valeur B obtenue à partir du calcul d'une moyenne à moyen terme des énergies de bruit reçues sur plusieurs fréquences voisines de la fréquence surveillée.

2. Dispositif selon la revendication 1, caractérisé en ce que les moyens (8) de détection des bruits impulsionnels détectent les bruits générant deux signaux simultanés sur deux fréquences distinctes de $\Delta f$, dont les énergies ont une valeur supérieure à un seuil de valeur S' variable et fonction de la valeur B, $\Delta f$ étant supérieur à l'excursion de fréquence maximale des émissions à détecter.

3. Dispositif selon la revendication 1, caractérisé en ce que les moyens (8) de détection des bruits impulsionnels détectent les bruits générant, sur une fréquence donnée, un signal d'énergie supérieure à un seuil S' variable en fonction de la valeur B, et de durée inférieure à une valeur $\Delta T$, prédéterminée, supérieure à la durée de la plupart des émissions parasites impulsionnelles.

4. Dispositif selon la revendication 1, caractérisé en ce que la valeur du seuil S'' est égale à la somme d'une valeur fixe et de la valeur B.

5. Dispositif selon l'une quelconque des revendications 2 ou 3, caractérisé en ce que la valeur du seuil S' est égale à la somme d'une valeur fixe et de la valeur B.

6. Dispositif selon la revendication 1, caractérisé en ce que la valeur moyenne B utilisée pendant un intervalle de temps de durée $\tau$, est déterminée par des moyens de calcul (28) de la moyenne des valeurs successives de l'énergie reçue pendant n intervalles de durée $\tau$ précédant l'intervalle considéré, et des valeurs successives de l'énergie reçue pendant n intervalles de durée $\tau$ suivant l'intervalle considéré, n étant un nombre entier positif suffisamment grand pour rendre négligeable les fluctuations de la valeur B d'un intervalle à un autre; et en ce qu'une de ces valeurs de l'énergie du signal reçu, $e_i$, est remplacée, pour le calcul de la valeur moyenne B de l'intervalle considéré, par une valeur moyenne B' calculée pendant l'intervalle immédiatement précédent, si $e_i$ dépasse un seuil M, ayant une valeur supérieure à la valeur B'.

7. Récepteur de surveillance, comportant un dispositif selon la revendication 1, caractérisé en ce que la valeur B, utilisée pour surveiller un certain canal de fréquences, est déterminée par des moyens de calcul de la moyenne des valeurs de l'énergie reçue au même instant dans n canaux dont la fréquence centrale est supérieure à la fréquence centrale du canal surveillé et des valeurs de l'énergie reçue au même instant dans n canaux dont la fréquence centrale est inférieure à la fréquence centrale du canal surveillé, n étant un nombre entier positif; la valeur de n et la largeur de bande des canaux étant telles que la bande passante des 2n canaux est suffisante pour rendre négligeable les fluctuations de la valeur moyenne B quand la surveillance est déplacée d'un canal au canal suivant; et une valeur, $e_i$, de l'énergie reçue dans un des canaux étant remplacée, pour le calcul de la valeur moyenne B, par la valeur moyenne B' calculée pour le canal surveillé précédemment, si $e_i$ dépasse un seuil M, ayant une valeur supérieure à la valeur moyenne B'.

8. Récepteur de surveillance de type superhétérodyne comportant un oscillateur local wobbulé (3), un changeur de fréquence (2), et un dispositif selon la revendication 2, caractérisé en ce qu'il comporte en outre deux filtres passe-bande (4 et 6) couplés à la sortie du changeur de fréquence (2), ayant des fréquences centrales fixes dont les valeurs diffèrent de $\Delta f$; deux amplificateurs logarithmiques (5 et 7) couplés respectivement aux sorties des filtres et alimentant respectivement deux détecteurs d'énergie (17 et 18) couplés à deux entrées (13 et 14) des moyens (8) de détection des bruits impulsionnels; et en ce que ces moyens (8) de détection des bruits impulsionnels comportent deux comparateurs analogiques (21 et 22) ayant des premières entrées reliées respectivement aux deux entrées (13, 14) des moyens (8) de détection des bruits impulsionnels, des deuxièmes entrées recevant la valeur analogique du seuil S', et des sorties reliées respectivement aux entrées de deux monostables (23 et 24), couplés respectivement aux entrées d'une porte logique ET (25), dont la sortie est reliée par un dispositif à retard (26) à la sortie (38) des moyens (8) de détection des bruits impulsionnels.

**Claims**

1. Device for reducing the false alarm proportion for a monitoring receiver monitoring a radio frequency band, comprising a gate (11) receiving a logical alarm signal when an emission is received on a monotored frequency and transmitting it if on the one hand it is enabled by means (10) for detecting signals whose energy is greater than a threshold value S'' and if, on the other hand, it is not inhibited by means (8) for detecting pulse interferences, characterized in that the value S'' is a function of a value B obtained from the calculation of a meanterm mean value of the noise energies received on a plurality of frequencies adjacent the monitored frequency.

2. Device according to claim 1, characterized in that the means (8) for detecting pulse noise detects the noise by generating two signals simultaneously on two frequencies different by $\Delta f$ whose energies have a value greater than a threshold value S' variable as a function of the value B, $\Delta f$ being greater than the maximum frequency excursion of the emissions to be detected.

3. Device according to claim 1, characterized in that the means (8) for detecting pulse noise detect the noise by generating on a given frequency a signal of energy greater than a variable threshold S' which is a function of the value B and of duration less than a predetermined value $\Delta T$ but greater than the duration of the majority of the parasitic pulse emissions.

4. Device according to claim 1, characterized in that the threshold value S'' is equal to the sum of a fixed value and the value B.

5. Device according to claim 2 or 3, characterized in that the threshold value S' is equal to the sum of a fixed value and the value B.

6. Device according to claim 1, characterized in that the mean value B used during an interval of time of duration $\tau$ is determined by computing means (28) calculating the mean value of the successive energy values received during n intervals of duration $\tau$ before the interval considered and of the successive energy values received during n intervals of duration $\tau$ after the interval considered, n being a positive whole number large enough to render negligible the fluctuations of the value B from one interval to the other; and that one of these energy values of the received signal, $e_i$, is replaced for the calculation of the mean value B of the interval considered by a mean value B' calculated during the immediately preceding interval when $e_i$ exceeds a threshold value M having a value greater than the value B'.

7. Monotoring receiver comprising a device according to claim 1, characterized in that the value B used to monitor a predetermined frequency channel is determined by computing means calculating the mean value of the energy values received at the same instant in n channels whose centre frequency is greater than the centre frequency of the monitored channel and of the energy values received at the same instant in n channels whose centre frequency is smaller than the centre frequency of the monitored channel, n being a positive whole number; the value of n and the bandwidth of the channels are such that the pass band of the 2 n channels is sufficient to render negligible the fluctuations of the mean value B when the monitoring is displaced from one channel to the following channel; and a value, $e_i$, of the energy received in one of the channels being replaced for the calculation of the mean value B by the means value B' calculated for the previously monitored channel if $e_i$ exceeds a threshold value M having a value greater than the mean value B'.

8. Monitoring receiver of the superheterodyne type comprising a swept local oscillator (3), a frequency changer (2) and a device according to claim 2, characterized in that it further comprises two bandpass filters (4, 6) coupled to the output of the frequency changer (2) and having fixed centre frequencies whose values differ by $\Delta f$; two logarithmic amplifiers (5 and 7) coupled respectively to the outputs of the filters and feeding respectively two energy detectors (17 and 18) coupled to two inputs (13 and 14) of the means (8) for detecting pulse noise; and that these pulse noise detection means (8) comprise two analog comparators (21 and 22) having first inputs connected respectively to the two inputs (13, 14) of the pulse noise detection means (8), two inputs receiving the analog threshold value S', and outputs connected respectively to the inputs of two monostable circuits (23 and 24) coupled respectively to the inputs of a logical AND circuit (25) whose output is connected by a delay device (26) to the output (38) of the pulse noise detection means (8).

**Patentansprüche**

1. Vorrichtung zur Verminderung der Fehlalarmquote für einen Überwachungsempfänger, der ein Funkfrequenzband überwacht, mit einer Torschaltung (11), die ein logisches Alarmsignal empfängt, wenn eine Ausstrahlung auf einer überwachten Frequenz empfangen wird, und es weiterleitet, wenn sie einerseits durch Mittel (10) zur Erfassung von Signalen, deren Energie einen Schwellwert S'' überschreitet, freigegeben ist und andererseits nicht durch Mittel (8) zur Erfassung von Impulsstörungen gesperrt ist, dadurch gekennzeichnet, dass der Wert S'' von einem Wert B abhängt, der aus der Berechnung eines mittelfristigen Mittelwertes der auf mehreren der überwachten Frequenz benachbarten Frequenzen empfangenen Rauschenergien erhalten wird.

2. Vorrichtung nach Anspruch 1, dadurch gekennzeichnet, dass die Mittel (8) zur Erfassung von Impulsstörungen die Störungen erfassen, indem zwei Signale gleichzeitig auf zwei um $\Delta f$ verschiedene Frequenzen erzeugt werden, deren Energien einen Wert aufweisen, der grösser als ein Schwellwert S' ist, welcher als Funktion des Wertes B variabel ist, worin $\Delta f$ grösser als der maximale Frequenzhub der zu erfassenden Ausstrahlungen ist.

3. Vorrichtung nach Anspruch 1, dadurch gekennzeichnet, dass die Mittel (8) zur Erfassung von Impulsstörungen die Störungen erfassen, indem sie auf einer gegebenen Frequenz ein Signal mit einer Energie erzeugen, die grösser ist als ein Schwellwert S', der als Funktion des Wertes B variabel ist, und mit einer Dauer, die kleiner als ein vorbestimmter Wert $\Delta T$, aber grösser als die Dauer der meisten Störimpulsausstrahlungen ist.

4. Vorrichtung nach Anspruch 1, dadurch gekennzeichnet, dass der Schwellwert S'' gleich der Summe aus einem festen Wert und dem Wert B ist.

5. Vorrichtung nach Anspruch 2 oder 3, dadurch gekennzeichnet, dass der Schwellwert S' gleich der Summe aus einem festen Wert und dem Wert B ist.

6. Vorrichtung nach Anspruch 1, dadurch gekennzeichnet, dass der Mittelwert B, der während eines Zeitintervalls der Dauer $\tau$ verwendet wird, durch Rechenmittel (28) bestimmt wird, welche den Mittelwert der aufeinanderfolgenden, während n Intervallen der Dauer $\tau$ vor dem betrachteten Intervall empfangenen Energiewerte und der aufeinanderfolgenden Energiewerte berechnen, die während n Intervallen der Dauer $\tau$ nach dem betrachteten Intervall empfangen werden, worin n eine ganze positive Zahl ist, die ausreichend gross ist, damit die Schwankungen des Wertes B von einem Intervall zum anderen vernachlässigbar gemacht werden; und dass einer dieser Energiewerte des empfangenen Signals, nämlich $e_i$, für die Berechnung des Mittelwertes B des betrachteten Intervalls ersetzt wird durch einen Mittelwert B', der während des unmittelbar vorausgehenden Intervalls berechnet wurde, wenn $e_i$ einen Schwellwert M überschreitet, dessen Grösse den Wert B' überschreitet.

7. Überwachungsempfänger mit einer Vorrichtung nach Anspruch 1, dadurch gekennzeichnet, dass der zur Überwachung eines bestimmten Frequenzkanals verwendete Wert B durch Rechenmittel bestimmt wird, welche den Mittelwert der zum gleichen Zeitpunkt in n Kanälen, deren Mittenfrequenz grösser als die Mittenfrequenz des überwachten Kanals ist, empfangenen Energiewerte und der Energiewerte berechnen, welche zur gleichen Zeit in n Kanälen empfangen werden, deren Mittenfrequenz kleiner als die Mittenfrequenz des überwachten Kanals ist, worin n eine ganze positive Zahl ist; wobei der Wert von n und die Bandbreite der Kanäle derart sind, dass das Durchlassband der 2 n Kanäle ausreicht, damit die Schwankungen des Mittelwertes B vernachlässigbar werden, wenn die Überwachung von einem Kanal zum nächsten verlegt wird; und wobei ein Wert $e_i$ der in einem der Kanäle empfangenen Energie zur Berechnung des Mittelwertes B durch den Mittelwert B' ersetzt wird, welcher für den zuvor überwachten Kanal berechnet wurde, wenn $e_i$ einen Schwellwert M überschreitet, dessen Grösse den Mittelwert B' überschreitet.

8. Überwachungsempfänger vom Superheterodyntyp, mit einem gewobbelten Lokaloszillator (3), einem Frequenzwechsler (2) und einer Vorrichtung nach Anspruch 2, dadurch gekennzeichnet, dass er ferner zwei Bandpassfilter (4 und 6) umfasst, die an den Ausgang des Frequenzwechslers (2) angekoppelt sind sowie feste Mittenfrequenzen aufweisen, deren Werte um $\Delta f$ verschieden sind; mit zwei logarithmischen Verstärkern (5 und 7), die an den Ausgang des einen bzw. anderen Filters angekoppelt sind und je einen von zwei Energiedetektoren (17 und 18) speisen, die an zwei Eingänge (13 und 14) der Mittel (8) zur Erfassung von Impulsstörungen angekoppelt sind; und dass diese Impulsstörungs-Erfassungsmittel (8) zwei analoge Komparatoren (21 und 22) umfassen, deren erster Eingang jeweils mit einem der zwei Eingänge (13, 14) der Impulsstörungs-Detektionsmittel (8) verbunden ist, während die zweiten Eingänge den analogen Schwellwert S' empfangen, mit Ausgängen, die jeweils an den Eingang einer von zwei monostabilen Schaltungen (23 und 24) angeschlossen sind, die an die beiden Eingänge einer logischen AND-Schaltung (25) angekoppelt sind, deren Ausgang über eine Verzögerungsvorrichtung (26) mit dem Ausgang (38) der Impulsstörungs-Detektionsmittel (8) verbunden ist.

FIG.1

# FIG. 2

3,3

FIG.3

```
        ┌──────────────┐
        │ CHOIX de la  │
        │ SOUS. GAMME  │
        └──────┬───────┘
        ┌──────┴───────┐
        │   P1 ← A1     │
        └──────┬───────┘
        ┌──────┴───────┐
        │   P2 ← A2     │
        └──────┬───────┘
        ┌──────┴───────┐
        │   B' ← BO     │
        └──────┬───────┘
        ┌──────┴───────┐
        │   B ← Bo      │
        └──────┬───────┘
        ┌──────┴───────┐
        │   ATTENTE     │◄─┐
        └──────┬───────┘  │
   OUI  ╱──────┴───────╲──┘
  ┌─────  DEBUT?
  │      ╲──────┬───────╱
  │             │ NON
```

$P1 \leftarrow A1$

$P2 \leftarrow A2$

$B' \leftarrow BO$

$B \leftarrow Bo$

ATTENTE

DEBUT? — OUI / NON

$B \leftarrow B'$

$S \leftarrow O$

$i \leftarrow 0$

$e \leftarrow e_i$

$i \leftarrow i+1$

$M \leftarrow B+20$

$i \leq 17$? — OUI / NON

$e_i > M$? — OUI / NON

$e \leftarrow B$

$e \leftarrow B'$

LECTURE $e(P1)$

$e(P1) \leftarrow e$

$S \leftarrow S - e.(P1)$

$e(P1) \leftarrow e$

$i = 9$? — OUI / NON

$S \leftarrow S + e(P1)$

$S \leftarrow S + e(P1)$

$P1 \leftarrow P1 + 1 [17]$

LECTURE $e(P2)$

$i = 17$? — NON / OUI

$S \leftarrow S + e(P2)$

$B = S/16$

$P2 \leftarrow P2 + 1 [17]$

$B' \leftarrow B$

$S \leftarrow S - e(P2)$

$B = S/16$

$P1 \leftarrow P1 + 1$

SORTIE de B